# EUROPÄISCHE PATENTSCHRIFT

(11) **EP 1 355 848 B1**
(45) Veröffentlichungstag und Bekanntmachung des Hinweises auf die Patenterteilung: **24.11.2004**
(21) Anmeldenummer: 01989549.9
(22) Anmeldetag: 30.11.2001
(51) Int. Cl.: B81C 1/00

(54) **VERFAHREN ZUR HERSTELLUNG EINES MIKROFLUIDBAUELEMENTS**
METHOD FOR PRODUCING A MCIROFLUIDIC COMPONENT
PROCEDE DE FABRICATION D'UN COMPOSANT MICROFLUIDIQUE

(30) Priorität: 05.12.2000 DE 10060433
(43) Veröffentlichungstag der Anmeldung: 29.10.2003
(60) Teilanmeldung: 03019362.7
(73) Patentinhaber: Febit AG, 68167 Mannheim (DE)
(72) Erfinder: STROBELT, Tilo, 73098 Rechberghausen (DE); FRECH, Johannes, 00920 Helsinki (FI); NOMMENSEN, Peter, 78054 Villingen-Schwenningen (DE); MÜLLER, Martin, 79331 Teningen (DE); STÄHLER, Cord-F., 69469 Weinheim (DE)
(74) Vertreter: Schoppe, Fritz, Dipl.-Ing.
(86) Internationale Anmeldenummer: PCT/EP2001/014036
(87) Internationale Veröffentlichungsnummer: WO 2002/046091

(56) Entgegenhaltungen:
- WO-A-00/11477
- WO-A-96/41864
- US-A- 5 498 392
- US-A- 5 744 366

## Beschreibung

Die vorliegende Erfindung bezieht sich auf die Analytik und insbesondere auf Fluidbauelemente, welche für analytische Anwendungen geeignet sind.

In der Analytik besteht ein großer Bedarf nach Fluidbauelementen und insbesondere nach Kapillarstrecken, um beispielsweise Flüssigkeiten durch Kapillarkräfte zu transportieren, um sie während des Transports untersuchen zu können, oder aber um Probebehälter zu erzeugen, in denen die Flüssigkeiten stehen, und deren Oberflächen mit chemischen Stoffen behandelt sind, damit bestimmte Probenfluide eine Reaktion mit diesen Stoffen eingehen, durch die sie beispielsweise eine Farbänderung erfahren. Um eine solche Farbänderung eines Probenfluids feststellen zu können, oder um allgemein die optischen Eigenschaften eines Probenfluids feststellen zu können, ist es wichtig, daß Fluidbauelemente auf beiden Seiten transparent sind, damit Analysen im Durchlicht beispielsweise unter Verwendung von Fluoreszenzeigenschaften durchgeführt werden können.

Kapillarstrecken werden heute in verschiedensten Bereichen der Technik, beispielsweise in der chemischen Analytik und Biochemie eingesetzt. Solche Kapillaren werden in Siliziumwafer geätzt und dann gedeckelt und damit verschlossen. So kann zum Verschließen solcher in Silizium geätzten Wafer zwar ein Glasdeckel verwendet werden. Rückseitig, also auf der anderen Seite der Kapillarstrecke, befindet sich jedoch der Substratwafer, welcher im allgemeinen nicht optisch transparent ist. Für Durchlichtanalysen sind solche Kapillarstrecken daher nicht geeignet. Um überhaupt optische Analysen mit solchen Kapillarstrecken durchführen zu können, muß auf die in das Silizium geätzten Fluidstrukturen z. B. eine Metallschicht aufgebracht werden, damit eine Reflexionsanalyse durchgeführt werden kann. Neben der Tatsache, daß solche Kapillarstrecken nicht für Durchlichtbestimmungen geeignet sind, ist das Aufbringen einer Spiegelschicht auf das Silizium ein weiterer Herstellungsschritt, welcher aufwendig ist und das Fluidbauelement verteuert.

Des weiteren ist es schwierig, mittels Ätzverfahren genaue Tiefen der Fluidstruktur einzustellen. So kann zwar mit der Trockenätztechnik ein sehr genau kontrollierbarer Materialabtrag erreicht werden. Nachteilig ist jedoch, daß die Ätzparameter sehr genau gesteuert werden müssen, was wiederum zu hohen Kosten solcher Kapillarbauelemente in der Herstellung führt. Werden die Ätzparameter nicht derart streng kontrolliert, so ergibt sich ein hoher Ausschuß in der Produktion.

Dokument WO 0011477 offenbart ein Verfahren wobei eine Fluidstruktur in einer Strukturschicht erzeugt wird. Eine Zwischenschicht liegt zwischen der Strukturschicht und ein Trägersubstrat. Die Dicke der Strukturschicht bestimmt die aktive Höhe der Fluidstruktur und die Strukturschicht wird ohne Beeintrachtigung der Zwischenschicht strukturiert. Der Trägersubstrat bleibt Teil der entgültige Struktur.

Dokument US 5,744,366 offenbart ein Fluidbauelement, der beidseitig transparent ist und in dem die Dicke der Strukturschicht die aktive Höhe der Fluidstruktur bestimmt, stellt aber kaum Herstellungsmerkmale dar.

Insbesondere auf dem Gebiet der Analytik setzen sich immer mehr Einweganalyseelemente durch. Fluidbauelemente entwickeln sich daher immer mehr zu Massenartikeln. Besonders an Massenartikel besteht die Anforderung, daß sie preisgünstig sind. Selbst kleine Preisunterschiede führen auf dem Markt daher bereits dazu, daß sich ein Produkt gegenüber einem anderen Produkt durchsetzt. Lediglich preiswerte Fluidbauelemente sind daher konkurrenzfähig.

Die Aufgabe der vorliegenden Erfindung besteht darin, ein preisgünstiges Verfahren zur Herstellung eines Fluidbauelements zu schaffen.

Diese Aufgabe wird durch ein Verfahren zur Herstellung eines Fluidbauelements nach Patentanspruch 1 oder 9 gelöst.

Der vorliegenden Erfindung liegt die Erkenntnis zugrunde, daß zur Herstellung eines Fluidbauelements ein Basiswafer verwendet wird, welcher ein Trägersubstrat, eine Zwischenschicht auf dem Trägersubstrat und eine Strukturschicht auf dem Trägersubstrat aufweist, wobei die Dicke der Strukturschicht die aktive Höhe der Fluidstruktur des Fluidbauelements bestimmt. Solche Basiswafer, welche beispielsweise SOI-Wafer sein können (SOI = Silicon On Insulator), werden mit genau spezifizierten Dicken der Halbleiterschicht angeboten. Im Falle von SOI-Wafern ist die zwischenschicht die Isolator/Oxid-Schicht, während die Strukturschicht die Halbleiterschicht ist.

Solche Basiswafer können industriell sehr genau hergestellt werden. Da solche Basiswafer in großen Stückzahlen industriell angeboten werden, sind ihre Preise vergleichsweise günstig, da sie nicht nur auf dem Gebiet der Analytik eingesetzt werden können, sondern im gesamten Bereich der Elektronik oder Mikrostrukturtechnik.

Erfindungsgemäß wird die Halbleiterschicht des Basiswafers, also im Falle eines SOI-Wafers die Siliziumschicht, strukturiert, um eine Fluidstruktur des Fluidbauelements herzustellen, wobei sich die Fluidstruktur durch die Halbleiterschicht hindurch erstreckt. Die zwischenschicht ist so ausgeführt, daß sie durch die Strukturierung der Strukturschicht im wesentlichen nicht beeinträchtigt wird und - im Falle von Ätzen - als Ätzstopp wirkt.

Dann wird eine transparente Scheibe aufgebracht, so daß die Fluidstruktur abgedeckt ist. Hierauf wird der Basiswafer von der anderen Seite bearbeitet, und zwar so, daß das Trägersubstrat und die Isolatorschicht entfernt werden. Die Fluidstruktur wird somit wieder an ihrer Rückseite geöffnet. Anschließend wird eine zweite transparente Scheibe auf der freiliegenden Seite der Halbleiterschicht angebracht, so daß die Fluidstruktur abgedeckt ist.

Falls die Zwischenschicht transparent ist, wie es bei SiO₂ der Fall ist, kann dieselbe auch verbleiben, da sie die Durchlichtanalysen nicht wesentlich beeinträchtigt.

Ein Vorteil der vorliegenden Erfindung besteht darin, daß nunmehr ein beidseitig transparentes Fluidbauelement geschaffen ist, das sich ohne weiteres für Durchlichtanalysen eignet.

Ein weiterer Vorteil der vorliegenden Erfindung besteht darin, daß die aktive Höhe der Fluidstruktur nicht mehr durch sehr genau gesteuerte Ätzparameter eingestellt werden muß, sondern einfach durch die Dicke der Halbleiterschicht bestimmt ist. Die Genauigkeit der aktiven Höhe der Fluidstruktur ist somit bereits vor der eigentlichen Herstellung des Fluidbauelements festgelegt, nämlich durch die vom Hersteller des Basiswafers spezifizierte Dicke der Halbleiterschicht.

Ein weiterer Vorteil der vorliegenden Erfindung besteht darin, daß während des Strukturierens der Halbleiterschicht Ätzverfahren eingesetzt werden können, welche nicht genau gesteuert zu werden brauchen. Vielmehr wirkt die Isolatorschicht des Basiswafers automatisch als Ätzstopp, so daß unabhängig von den Ätzparametern immer eine sehr genaue aktive Höhe der Fluidstruktur erreicht wird. Die einzige Anforderung besteht dahingehend, daß die Halbleiterschicht vollständig durchgeätzt wird, um eine Fluidstruktur mit konstanter Höhe zu erreichen.

Ein weiterer Vorteil der vorliegenden Erfindung besteht darin, daß mittels des gleichen Herstellungsverfahrens Fluidbauelemente für viele verschiedenen Anwendungen, also mit vielen verschiedenen entsprechenden aktiven Höhen der Fluidstrukturen einfach dadurch erhalten werden können, daß andere Basiswafer mit anderen Dicken der Halbleiterschichten ausgewählt werden. Da somit das gleiche Herstellungsverfahren für eine Vielzahl verschiedener Fluidbauelemente eingesetzt werden kann, verringern sich die Herstellungskosten pro Fluidbauelement, da selbst Kleinserien von Fluidbauelementen verschiedener Spezifikationen hergestellt werden können, ohne daß nach jeder Kleinserie eine aufwendige Umstellung der Produktionsanlage erforderlich ist.

Dies alles wird dadurch erreicht, daß der entscheidende Parameter, nämlich die aktive Höhe der Fluidstruktur, nicht mehr durch den Herstellungsprozeß selber, sondern durch das Ausgangsmaterial, nämlich den Basiswafer, festgelegt wird.

Erfindungsgemäß können somit beidseitig mit transparenten Scheiben, beispielsweise Glasdeckeln, verschlossene Fluidbauelemente mit hoher Präzision hergestellt werden. Die Genauigkeit wird also nicht mehr durch das Herstellungsverfahren bestimmt, sondern durch die Verwendung von Basiswafern. Aufgrund der Tatsache, daß die Fluidstrukturen durch Standard-Halbleitertechnologie-Prozeßschritte erreicht werden können, können auch sehr komplizierte Fluidstrukturen mit beliebigen Geometrien auf einem Basiswafer hergestellt werden, so daß das erfindungsgemäße Verfahren nicht zur Herstellung von Kapillarstrecken eingesetzt werden kann, sondern auch zur Herstellung von Kavitäten, Verzweigungen, passiven Ventilen und dergleichen.

Bevorzugte Ausführungsbeispiele der vorliegenden Erfindung werden nachfolgend bezugnehmend auf die beiliegenden Zeichnungen erläutert. Es zeigen:
- Fig. 1: eine Schnittansicht eines Basiswafers nach dem Schritt des Strukturierens der Halbleiterschicht;
- Fig. 2: eine Schnittansicht durch einen Basiswafer, auf dem eine erste transparente Scheibe aufgebracht ist;
- Fig. 3: eine Schnittansicht des Basiswafers, nachdem das Trägersubstrat und die Isolatorschicht entfernt ist; und
- Fig. 4: eine Schnittansicht eines erfindungsgemäßen Fluidbauelements, nachdem eine zweite transparente Scheibe an der Rückseite des Fluidbauelements angebracht worden ist.

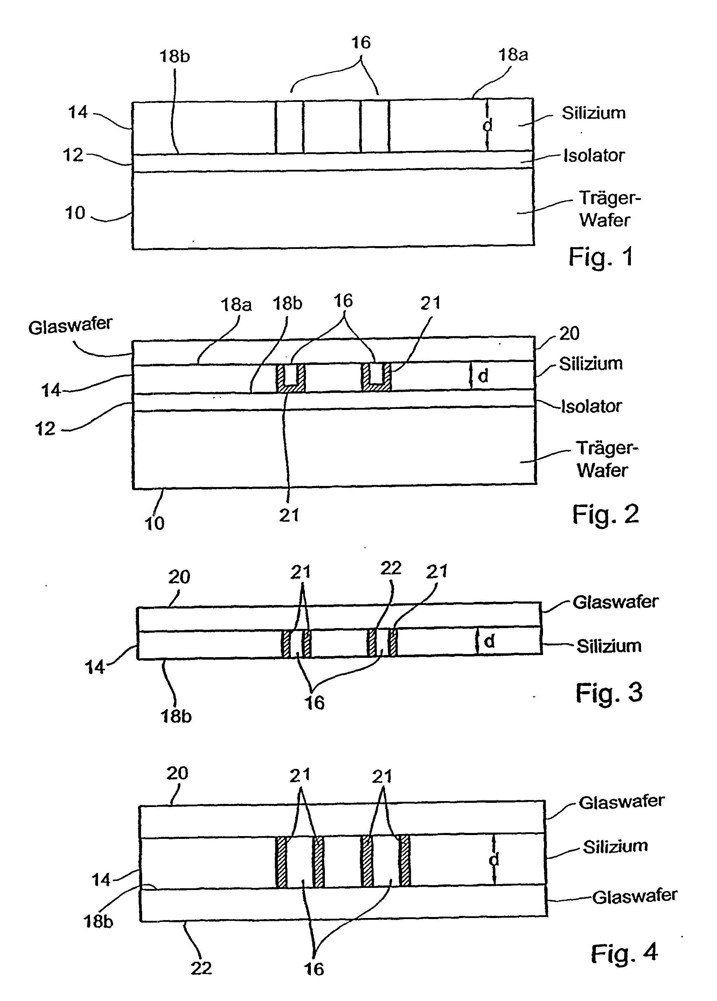

Fig. 1 zeigt einen Basiswafer mit einem Trägerwafer 10, auf dem eine Isolatorschicht 12 aufgebracht ist, welche wiederum von einer Halbleiterschicht 14 bedeckt ist. Vorzugsweise wird als Basiswafer eine SOI-Struktur verwendet, also eine Struktur, bei der die Halbleiterschicht aus Silizium ist, die Isolatorschicht aus Siliziumoxid besteht, und der Trägerwafer ebenfalls aus Silizium hergestellt ist. In Fig. 1 ist bereits eine Fluidstruktur 16 eingezeichnet, welche vorzugsweise durch Trockenätzen der Siliziumschicht 14 hergestellt wird. Wie es in der Technik bekannt ist, wird vor dem Trockenätzen ein Photolack auf der Halbleiterschicht aufgebracht, welcher dann an den Stellen, an denen die Fluidstruktur 16 entstehen soll, belichtet wird.

Die vorliegende Erfindung ist genauso auch auf sämtliche Trägerstruktur-Zwischenschicht-Strukturschicht-Systeme anwendbar, bei denen die zwischenschicht so beschaffen ist, daß sie durch ein Strukturierungsverfahren zum Strukturieren der Strukturschicht im wesentlichen nicht beeinträchtigt wird. Dann ist die Höhe der aktiven Struktur allein durch die Dicke der Strukturschicht festgelegt und wird nicht durch das Strukturierungsverfahren bestimmt, da die Zwischenschicht beim Strukturieren der Strukturschicht nicht beeinträchtigt wird.

Die Halbleiterschicht wird derart strukturiert, daß sich die Fluidstruktur 16 von einer ersten Oberfläche 18a der Siliziumschicht bis zu einer zweiten Oberflächen 18b der Siliziumschicht 14 erstreckt. Die vergrabene Oxidschicht 12 dient für das Trockenätzverfahren als Stoppschicht und sorgt somit für eine hohe Genauigkeit bezüglich der späteren Höhe der fluidischen Strukturen, welche nämlich durch die Dicke der Siliziumschicht d bestimmt wird, die durch den Hersteller des SOI-Wafers in sehr engen Toleranzen spezifiziert ist.

Fig. 2 zeigt eine Schnittansicht durch den Basiswafer, auf dem jedoch nunmehr ein Glaswafer 20 aufgebracht ist, welcher die Fluidstruktur 16 abdeckt. Selbstverständlich kann statt eines Glaswafers 20 jede andere transparente Scheibe auf die Siliziumschicht 14 aufgebracht werden. Zum Anbringen der transparenten Scheibe auf dem Silizium wird jedoch das anodische Bonden bevorzugt, für das sich Glas am besten eignet.

Bei Bedarf kann die Fluidstruktur 16 vor dem Verschließen mit dem Glaswafer 20 mit einer Oxidschicht passiviert werden, welche in Fig. 2 mit dem Bezugszeichen 21 gekennzeichnet ist. Die Oxidschicht 21 kann jedoch weggelassen werden, wenn es für die spätere Anordnung unerheblich ist, ob das Silizium passiviert ist.

Anschließend wird der Trägerwafer 10 von der Rückseite aus durch Schleifen, Ätzen und dergleichen entfernt. Wiederum dient die Oxidschicht 12 als Stoppschicht für einen Ätzprozeß. Anschließend kann die Oxidschicht 12 entfernt werden, so daß die Fluidstruktur 16 gewissermaßen von der Rückseite her wieder geöffnet wird. Ist die Oxidschicht transparent, so kann sie auch verbleiben und wird nicht entfernt.

Zum Entfernen der Zwischenschicht, die als Ätzstopp gewirkt hat, kann ein anderes Ätzverfahren eingesetzt werden, bei dem die Zwischenschicht geätzt wird, während die Strukturschicht als Ätzstopp wirkt.

Im Falle eines Silizium-Siliziumoxid-Systems kann zum Siliziumätzen KOH verwendet werden, das Siliziumoxid nicht angreift. Zum Entfernen der Isolatorschicht kann dagegen Flußsäure verwendet werden, welche Silizium nicht angreift.

Fachleuten sind viele weiteren Material-Systeme bekannt, bei denen zwei Schichten vorhanden sind, bei denen eine durch ein Strukturieren der anderen nicht beeinträchtigt wird.

Diese Situation ist in Fig. 3 dargestellt. Es ist zu sehen, daß durch Entfernen des Trägersubstrats und der Isolatorschicht sowie optional der Passivierungsschicht am Boden der Fluidstruktur die Fluidstruktur an der zweiten Oberfläche 18b freiliegend ist, wobei die aktive Höhe der Fluidstruktur lediglich durch die Dicke der Siliziumschicht der SOI-Struktur bestimmt ist.

In Fig. 4 ist ein fertiges Fluidbauelement gezeigt, bei dem im Vergleich zu Fig. 3 lediglich an der zweiten Oberfläche 18b eine zweite transparente Scheibe 22 angebracht ist, welche im Falle von Silizium als Halbleiterschicht 14 vorzugsweise ebenfalls ein Glaswafer ist, da dieser durch anodisches Bonden günstig mit dem Silizium 14 verbunden werden kann.

Das in Fig. 4 gezeigte Fluidbauelement zeichnet sich somit dadurch aus, daß es oben und unten einen Deckel aus Glas aufweist, und daß die Höhe der Fluidstruktur des Fluidbauelements, die in den Figuren mit d bezeichnet ist, der Dicke der Halbleiterschicht 14 entspricht.

Es sei darauf hingewiesen, daß die Anschlüsse der fluidischen Strukturen nach außen entweder seitlich oder durch Strukturierung von Durchlässen in den Glaswafern 20 und 22 erzeugt werden können.

Ein bevorzugtes Anwendungsbeispiel der erfindungsgemäßen Fluidbauelemente besteht darin, dieselben in Verbindung mit einer Analysevorrichtung zu verwenden, die mit Durchlicht arbeitet. Hierzu wird ein Probefluid, das sich innerhalb der Fluidstruktur 16 befindet, unter Verwendung einer Lichtquelle beispielsweise von der oberen Seite aus, also durch den ersten Glaswafer 20 hindurch, beleuchtet. Mittels eines Lichtempfängers wird dann das Transmissionslicht durch das Probenfluid erfaßt, nachdem es durch den zweiten Glaswafer hindurchgetreten ist. Ein Probenfluidanalysator kann dann Eigenschaften des Probenfluids unter Verwendung des Spektrums des eingestrahlten Lichts und unter Verwendung des Spektrums des transmittierten Lichts bestimmen.

Die erfindungsgemäßen Fluidbauelemente können vorteilhaft in der In-Vitro-Diagnostik oder klinischen Diagnostik, der biologischen Grundlagenforschung, insbesondere Genomik, der Forensik, der Lebensmittelanalytik oder dem Screening von medizinischen Produkten eingesetzt werden.

Für die einzelnen Anwendungen können auf der Oberfläche der Fluidstruktur immobilisierte Biomaterialien, wie z. B. DNA-Oligonukleotide, angeordnet sein, die als spezifische Interaktionspartner dienen können und damit Funktionselemente definieren. Wenn die Fluidstruktur in Reihen und Spalten ausgestaltet ist, werden die Fluidbauelemente auch als Bio-Chip-Arrays bezeichnet. Es können beliebige Anzahlen (bis zu mehreren Tausend) von biochemischen Funktionselementen angeordnet sein

Die Biomaterialien können unter Verwendung von verschiedenen Verfahren auf der Halbleiter-Fluidstruktur aufgebracht sein, wie z. B. durch Synthese von DNA-Oligos direkt auf der Trägermatrix unter Verwendung von photolithographischen Masken, oder durch Aufspotten von synthetisierten Oligos auf Träger.

Flüssige Einsatzstoffe werden bei der DNA-Arraysynthese durch die Kapillaren des Fluidbauelements in den Chip geführt und binden durch lokale Lichtaktivation an den Kapillarwänden, wie es z. B. in der DE 19940750 A1 beschrieben ist. Damit wird eine schnelle, effiziente und damit kostengünstige Herstellung von Biochips erreicht, so daß sich solche Chips als Massenartikel durchsetzen können. Im Vergleich zu einheitlichen Oberflächen liefern die erfindungsgemäßen Fluidbauelemente günstigere physio-chemische Eigenschaften der Strömungs- und Benetzungsvorgänge in den Fluidstrukturen, insbesondere wenn dieselben solche Dimensionen haben, daß sie als Kapillaren wirken.

## Patentansprüche

1. Verfahren zur Herstellung eines Fluidbauelements mit einer Fluidstruktur (16), die eine aktive Höhe (d) aufweist, mit folgenden Schritten:
Bereitstellen eines Basiswafers mit einem Trägersubstrat (10), einer Zwischenschicht (12) auf dem Trägersubstrat und einer Strukturschicht (14) auf der Zwischenschicht (12), wobei die Dicke der Strukturschicht (14) die aktive Höhe (d) der Fluidstruktur (16) bestimmt, wobei die Zwischenschicht (12) derart beschaffen ist, daß sie durch eine Strukturierung der Strukturschicht im wesentlichen nicht beeinträchtigt wird;
Strukturieren der Strukturschicht (14), um die Fluidstruktur (16) des Fluidbauelements herzustellen, wobei sich die Fluidstruktur (16) von einer ersten Oberfläche (18a) der Strukturschicht (14) bis zu der Zwischenschicht (12) erstreckt;
Anbringen einer ersten transparenten Scheibe (20), so daß die Fluidstruktur (16) abgedeckt ist;
Entfernen des Trägersubstrats (10) und der Zwischenschicht (12), so daß die Fluidstruktur (16) an einer zweiten Oberfläche (18b) der Strukturschicht (14) freiliegt; und
Anbringen einer zweiten transparenten Scheibe (22), so daß die Fluidstruktur abgedeckt ist.

2. Verfahren nach Anspruch 1, bei dem der Basiswafer eine SOI-Struktur ist, die einen Trägerwafer (10) aus Silizium, eine Isolatorschicht (12) aus Oxid als Zwischenschicht und eine Siliziumschicht (14) als Strukturschicht auf der Oxidschicht (12) aufweist.

3. Verfahren nach Anspruch 2, bei dem der Schritt des Strukturierens mittels Trockenätzen von Silizium ausgeführt wird, wobei die Oxidschicht (12) als Ätzstopp wirkt.

4. Verfahren nach einem der vorhergehenden Ansprüche, bei dem die erste transparente Scheibe (20) ein Glaswafer ist, der mittels anodischem Bonden an der Strukturschicht (14) angebracht wird.

5. Verfahren nach einem der Ansprüche 1 bis 3, bei dem vor dem Schritt des Anbringens der ersten transparenten Scheibe (20) die Fluidstruktur mittels einer Oxidschicht (21) passiviert wird.

6. Verfahren nach einem der vorhergehenden Ansprüche, bei dem die zweite transparente Scheibe (22) ein Glaswafer ist, der mittels anodischem Bonden an der zweiten Oberfläche (18b) der Strukturschicht (14) angebracht wird.

7. Verfahren nach einem der vorhergehenden Ansprüche, bei dem im Schritt des Entfernens des Trägersubstrats (10) und der Zwischenschicht (12) das Trägersubstrat durch Ätzen entfernt wird, wobei die Zwischenschicht (12) als Ätzstopp wirkt, woraufhin das Ätzverfahren verändert wird, so daß die Zwischenschicht geätzt wird und die Strukturschicht als Ätzstopp wirkt.

8. Verfahren nach einem der vorhergehenden Ansprüche, bei dem das Fluidbauelement eine Kapillarstrecke ist, wobei im Schritt des Bereitstellens ein Basiswafer ausgewählt wird, dessen Strukturschicht (14) eine solche Höhe (d) aufweist, daß ein zu transportierendes Fluid in der Fluidstruktur durch Kapillarkräfte transportierbar ist.

9. Verfahren zur Herstellung eines Fluidbauelements mit einer Fluidstruktur (16), die eine aktive Höhe (d) aufweist, mit folgenden Schritten:
Bereitstellen eines Basiswafers mit einem Trägersubstrat (10), einer Zwischenschicht (12) auf dem Trägersubstrat und einer Strukturschicht (14) auf der Zwischenschicht (12), wobei die Zwischenschicht (12) transparent ist und derart beschaffen ist, daß sie durch eine Strukturierung der Strukturschicht im wesentlichen nicht beeinträchtigt wird, und wobei die Dicke der Strukturschicht (14) die aktive Höhe (d) der Fluidstruktur (16) bestimmt;
Strukturieren der Strukturschicht (14), um die Fluidstruktur (16) des Fluidbauelements herzustellen, wobei sich die Fluidstruktur (16) von einer ersten Oberfläche (18a) der Strukturschicht (14) bis zu der Zwischenschicht (12) erstreckt;
Anbringen einer ersten transparenten Scheibe (20), so daß die Fluidstruktur (16) abgedeckt ist;
Entfernen des Trägersubstrats (10), so daß die transparente Zwischenschicht (12) freiliegt; und
Anbringen einer zweiten transparenten Scheibe (22) auf der Zwischenschicht (12).

## Claims

1. A method of producing a fluid device with a fluid structure (16) having an active height (d), said method comprising the following steps:
providing a basic wafer comprising a supporting substrate (10), an intermediate layer (12) on the supporting substrate and a patterned layer (14) on the intermediate layer (12), the thickness of the patterned layer (14) determining the active height (d) of the fluid structure (16), said intermediate layer (12) being of such a nature that it is essentially not impaired by a patterning of the patterned layer;
patterning the patterned layer (14) so as to produce the fluid structure (16) of the fluid device, the fluid structure (16) extending from a first surface (18a) of the patterned layer (14) to the intermediate layer (12);
attaching a first transparent wafer (20) so that the fluid structure (16) is covered;
removing the supporting substrate (10) and the intermediate layer (12) so that the fluid structure (16) is exposed at a second surface (18b) of the patterned layer (14); and
attaching a second transparent wafer (22) so that the fluid structure is covered.

2. A method according to claim 1, wherein the basic wafer is an SOI structure comprising a supporting wafer (10) of silicon, an insulating layer (12) of oxide as an intermediate layer and a silicon layer (14) as a patterned layer on the oxide layer (12).

3. A method according to claim 2, wherein the patterning step is carried out by means of dry etching silicon, the oxide layer (12) acting as an etch stop.

4. A method according to one of the preceding claims, wherein the first transparent wafer (20) is a glass wafer which is attached to the patterned layer (14) by means of anodic bonding.

5. A method according to one of the claims 1 to 3, wherein the fluid structure is passivated by means of an oxide layer (12) prior to the step of attaching the first transparent wafer (20).

6. A method according to one of the preceding claims, wherein the second transparent wafer (22) is a glass wafer which is attached to the second surface (18b) of the patterned layer (14) by means of anodic bonding.

7. A method according to one of the preceding claims, wherein, in the step of removing the supporting substrate (10) and the intermediate layer (12), the supporting substrate is removed by etching, the intermediate layer (12) acting as an etch stop, whereupon the etching method is changed so that the intermediate layer is etched and the patterned layer acts as an etch stop.

8. A method according to one of the preceding claims, wherein the fluid device is a capillary path, the providing step including the step of selecting a basic wafer whose patterned layer (14) has a height (d) of such a nature that a fluid to be transported in the fluid structure is transportable by capillary forces.

9. A method of producing a fluid device with a fluid structure (16) having an active height (d), said method comprising the following steps:
providing a basic wafer comprising a supporting substrate (10), an intermediate layer (12) on the supporting substrate and a patterned layer (14) on the intermediate layer (12), said intermediate layer (12) being transparent and of such a nature that it is essentially not impaired by a patterning of the patterned layer, and wherein the thickness of said patterned layer (14) determines the active height (d) of the fluid structure (16);
patterning the patterned layer (14) so as to produce the fluid structure (16) of the fluid device, the fluid structure (16) extending from a first surface (18a) of the patterned layer (14) to the intermediate layer (12);
attaching a first transparent wafer (20) so that the fluid structure (16) is covered;
removing the supporting substrate (10) so that the transparent intermediate layer (12) is exposed; and
attaching a second transparent wafer (22) on the intermediate layer (12).

## Revendications

1. Procédé de fabrication d'un composant à fluide avec une structure à fluide (16) présentant une hauteur active (d), aux étapes suivantes consistant à :
préparer une plaquette de base avec un substrat de support (10), une couche intermédiaire (12) sur le substrat de support et une couche de structure (14) sur la couche intermédiaire (12), l'épaisseur de la couche de structure (14) déterminant la hauteur active (d) de la structure à fluide (16), la couche intermédiaire (12) étant réalisée de telle sorte qu'elle ne soit sensiblement pas dégradée par une structuration de la couche de structure ;
structurer la couche de structure (14), pour réaliser la structure à fluide (16) du composant à fluide, la structure à fluide (16) s'étendant d'une première surface (18a) de la couche de structure (14) à la couche intermédiaire (12) ;
appliquer une première plaquette transparente (20), de sorte que la structure à fluide (16) soit recouverte ;
éliminer le substrat de support (10) et la couche intermédiaire (12), de sorte que la structure à fluide (16) soit exposée à une deuxième surface (18b) de la couche de structure (14) ; et
appliquer une deuxième plaquette transparente (22), de sorte que la structure à fluide soit recouverte.

2. Procédé selon la revendication 1, dans lequel la plaquette de base est une structure SOI présentant une plaquette de support (10) en silicium, une couche d'isolation (12) en oxyde comme couche intermédiaire et une couche de silicium (14) comme couche de structure sur la couche d'oxyde (12).

3. Procédé selon la revendication 2, dans lequel l'étape de structuration est effectuée par gravure à sec de silicium, la couche d'oxyde (12) agissant comme arrêt de gravure.

4. Procédé selon l'une des revendications précédentes, dans lequel la première plaquette transparente (20) est une plaquette de verre qui est appliquée sur la couche de structure (14) par assemblage anodique.

5. Procédé selon l'une des revendications 1 à 3, dans lequel la structure à fluide est passivée, avant l'étape d'application de la première plaquette transparente (20), au moyen d'une couche d'oxyde (21).

6. Procédé selon l'une des revendications précédentes, dans lequel la deuxième plaquette transparente (22) est une plaquette de verre qui est appliquée sur la deuxième surface (18b) de la couche de structure (14) par assemblage anodique.

7. Procédé selon l'une des revendications précédentes, dans lequel le substrat de support est, à l'étape d'élimination du substrat de support (10) et de la couche intermédiaire (12), éliminé par gravure, la couche intermédiaire (12) agissant d'arrêt de gravure, après quoi le procédé de gravure est changé, de sorte que soit gravée la couche intermédiaire et que la couche de structure agisse comme arrêt de gravure.

8. Procédé selon l'une des revendications précédentes, dans lequel le composant à fluide est un trajet capillaire, à l'étape de préparation étant choisie une plaquette de base dont la couche de structure (14) présente une hauteur (d) telle qu'un fluide à transporter dans la structure à fluide puisse être transporté par des forces capillaires.

9. Procédé de fabrication d'un composant à fluide avec une structure à fluide (16) présentant une hauteur active (d), aux étapes suivantes consistant à :
préparer une plaquette de base avec un substrat de support (10), une couche intermédiaire (12) sur le substrat de support et une couche de structure (14) sur la couche intermédiaire (12), la couche intermédiaire (12) étant transparente et réalisée de telle sorte qu'elle ne soit sensiblement pas dégradée par une structuration de la couche de structure et l'épaisseur de la couche de structure (14) déterminant la hauteur active (d) de la structure à fluide (16) ;
structurer la couche de structure (14), pour réaliser la structure à fluide (16) du composant à fluide, la structure à fluide (16) s'étendant d'une première surface (18a) de la couche de structure (14) à la couche intermédiaire (12) ;
appliquer une première plaquette transparente (20), de sorte que la structure à fluide (16) soit recouverte ;
éliminer le substrat de support (10), de sorte que la couche intermédiaire transparente (12) soit exposée ; et
appliquer une deuxième plaquette transparente (22) sur la couche intermédiaire (12).
